# EUROPÄISCHE PATENTSCHRIFT

(11) **EP 1 189 018 B1**
(45) Veröffentlichungstag und Bekanntmachung des Hinweises auf die Patenterteilung: **25.02.2009**
(21) Anmeldenummer: 01120844.4
(22) Anmeldetag: 30.08.2001
(51) Int. Cl.: G01B 11/27, G01B 11/00, H01L 21/00, G03F 7/20

(54) **Sechsachsiges Positioniersystem mit magnetfeldfreiem Raum**
Six axes positioning system with a space free from magnetic field
Système de positionnement à six axes avec espace libre de champs magnétique

(30) Priorität: 15.09.2000 DE 10046144
(43) Veröffentlichungstag der Anmeldung: 20.03.2002
(73) Patentinhaber: Vistec Electron Beam GmbH, 07745 Jena (DE)
(72) Erfinder: Kirschstein, Ulf-Carsten, 7751 Jenapriessnitz (DE); Beckert, Erik, 99310 Arnstadt (DE); Hoffmann, Andrew, 98693 Ilmenau (DE); Schäffel, Christoph, Dr. Ing., 98693 Ilmenau (DE); Saffert, Eugen, 98693 Ilmenau (DE); Zentner, Johannes, 98693 Ilmenau (DE); Gramsch, Torsten, 98693 Ilmenau (DE)
(74) Vertreter: Freitag, Joachim

(56) Entgegenhaltungen:
- US-A- 5 139 383
- US-A- 6 038 013

## Beschreibung

Die Erfindung bezieht sich auf eine Anordnung zum Positionieren von Substraten, insbesondere zum Positionieren von Wafern innerhalb einer Einrichtung, die zum Belichten der Substrate und/oder zum Messen an den Substraten mittels Strahlung unter Hochvakuumbedingungen vorgesehen ist.

Derartige Anordnung finden vor allem in der Halbleiterindustrie bei der Chipherstellung Anwendung, siehe z.B. US-5 139 383. Dort besteht bei neuen Lithographieansätzen immer häufiger der Bedarf nach neuartigen, komplexen Antriebssystemen für besondere Einsatzbedingungen wie Hochvakuum und Umgebungen mit minimalen magnetischen oder elektrostatischen Störfeldern. Dabei werden Positioniertische verwendet, auf denen die Substrate, insbesondere Wafer, abgelegt sind. Durch Verschieben der Tische werden die Substrate in die geeignete Position zur Belichtung bzw. Vermessung gebracht.

Immer kleiner werdende Strukturgrößen in der Halbleitertechnik lassen die klassische lichtoptische Lithographie zur Belichtung von Wafern an ihre physikalischen Grenzen stoßen. Zunehmend werden daher auch Verfahren, wie zum Beispiel die lonenstrahl-, die Elektronenstrahl- oder die EUV- (extremes ultraviolettes Licht) Lithographie, zum Ziel industrieller Anstrengungen. Diese Verfahren stellen gewöhnlich hohe Anforderungen an das Equipment, sei es durch ihre Anwendung unter Vakuumbedingungen oder ihre Sensibilität gegenüber Störfeldern elektrostatischer oder magnetischer Natur. Insbesondere werden diese Anforderungen an einen Wafertisch zur Positionierung des Wafers während des lonenstrahl-Lithographieprozesses gestellt.

Das Verfahren zur Waferbelichtung mittels lonenstrahl erfordert einen Wafertisch zur Positionierung des Wafers in Bezug auf den belichtenden Strahl. Der Belichtungsprozeß selbst benötigt eine lonenquelle sowie eine Säule aus elektrostatischen Linsen zur Fokussierung des Strahls. Daraus ergeben sich Besonderheiten für die Waferpositionierung. Die Empfindlichkeit des lonenstrahls gegenüber elektrostatischen und magnetischen Störungen erfordert die Eliminierung möglicher Störquellen in unmittelbarer Umgebung des Belichtungsortes und die sorgfältige Schirmung solcher (zum Beispiel die Antriebe des Wafertischs) in der weiteren Umgebung.

Zudem arbeiten nichtoptische Belichtungsverfahren üblicherweise unter Hochvakuumbedingungen (hier 10⁻⁶mbar). Dies führt zu Problemen des Ausgasens von Werkstoffen und der thermischen Belastung von Leistungsbauteilen. Eingesetzte Antriebe müssen daher verlustleistungsoptimiert ausgewählt und möglichst mit einer Kühlung versehen werden. Der Einsatz nichtvakuumtauglicher Materialien verbietet sich. Reibung und Verschleiß müssen minimiert bzw. sogar eliminiert werden.

Weiterhin soll der Wafertisch die Belichtung von Wafern unterschiedlicher Größe ermöglichen, insbesondere von 300mm-Wafern und hierzu einen Fahrbereich von mindestens 310x310mm² besitzen. Zum Ausgleich von Keilfehlern und Fokuslagenabweichungen des Wafers müssen Bewegungen des Wafers in möglichst vielen Raumfreiheitsgraden realisiert werden. Zur Unterstützung des elektronischen Strahlnachführungssystems (welches im Nanometerbereich arbeitet) wird eine erreichbare Positionsruhe und -genauigkeit im Submikrometer- bzw. Mikrorad-Bereich angestrebt. Die Vermessung optischer Referenzmarken auf der Waferoberfläche, die zur Kopplung des lonenstrahls mit dem Wafer benötigt werden, erfordern zumindestens partiell gleichförmige Verfahrgeschwindigkeiten mit einer Abweichung kleiner 2%. Nicht zuletzt soll der Wafertisch einen hohen Durchsatz belichteter Wafer pro Zeiteinheit (Throughput) ermöglichen und deshalb gute dynamische Eigenschaften besitzen.

Der Stand der Technik bietet keine vergleichbaren Systeme, die für derart unterschiedliche Eigenschaften wie Betrieb im Hochvakuum, vertikale Arbeitsebene des Positioniersystems, Kompensation der Gewichtskraft der Läuferanordnung durch Magnetkräfte sowie Schirmung entstehender Magnetfelder bis auf einen Restwert im Nano-Tesla-Bereich ausgelegt sind und eine Kombination dieser Lösungen in einem Gerät vereinen.

Herkömmliche Positioniersysteme für hohe Präzision erfüllen die gestellten Anforderungen an die Genauigkeit und Dynamik meist dadurch, daß eine Führung der Bewegungselemente aerostatisch erfolgt. Das ermöglicht jedoch nicht den Einsatz dieser Anlagen im Vakuum. US-6 038 013 beschreibt ein Positioniersystem mit einem verstellbaren Tisch.

Von diesem Stand der Technik ausgehend besteht die Aufgabe der Erfindung darin, die Positioniersysteme dahingehend weiterzuentwickeln, daß eine höhere Genauigkeit der Positionierung als Voraussetzung für die exakte Belichtung und Messung immer feinerer Strukturen auch unter Hochvakuum erreicht wird.

Erfindungsgemäß ist hierfür eine Anordnung zum Positionieren von Substraten der eingangs beschriebenen Art vorgesehen, welche umfaßt: ein auf einer Geradführung verschiebliches Haltesystem zur Aufnahme des Substrates, wobei die Führungsrichtung der Geradführung parallel oder im wesentlichen parallel zur Koordinate Y eines Raumkoordinatensystems X, Y, Z ausgerichtet ist; Antriebe zur Neigungsänderung der Führungsrichtung relativ zur Koordinate Y; Antriebe zur Drehung der Geradführung einschließlich des Haltesystems um die Führungsrichtung sowie Antriebe zur Parallelverschiebung der Geradführung einschließlich des Haltesystems in Richtung der Koordinate X, in Richtung der Koordinate Y und/oder in Richtung der Koordinate Z.

Der Erfindung liegt ein neuartiges sechsachsiges Positioniersystem mit magnetfeldfreiem Raum, geeignet zum Einsatz im Hochvakuum für flache Substrate, insbesondere Wafer, in Verbindung mit Belichtungsanlagen und Meßgeräten unter Verwendung geladener Teilchen zur Bestrahlung, bei welchen hohe Forderungen zur Vermeidung von störenden Magnetfeldern im Teilchenstrahlbereich bestehen, zugrunde. Dieses Positioniersystem zeichnet sich durch hohe Präzision und Dynamik in allen Bewegungsachsen sowie hohe Steifigkeit aus.

In einer besonders bevorzugten Ausgestaltung der Erfindung sind zwei Antriebseinheiten vorgesehen, von denen jede einen Stator und einen Läufer mit veränderlichem Luftspalt zueinander aufweist, wobei die Läufer in Richtung X verschieblich und jeder Läufer mit dem entgegengesetzten Ende der Geradführung für das Haltesystem verbunden ist. Bei synchroner Verschiebung beider Läufer die Parallelverschiebung in Richtung X, dagegen bei asynchroner Verschiebung beider Läufer eine Änderung der Neigung in Richtung X (mit anderen Worten: eine Drehung um die Richtung Z erfolgt) und bei synchroner Veränderung der Luftspalte in beiden Linearmotoren eine Parallelverschiebung in der Richtung Z oder eine Drehung um die Richtung Y, dagegen bei asynchroner Veränderung der Luftspalte in beiden Linearmotoren die Änderung der Neigung in Richtung Z (mit anderen Worten: eine Drehung um die Richtung X erfolgt).

Damit lassen sich wahlweise Parallelverschiebungen in Richtung der Koordinaten X und/oder Z bzw. Drehungen um die Richtungen X, Y und/oder Z realisieren.

Jeder Stator enthält für den Einsatz unter Vakuum bevorzugt die Antriebsspulen eines in X-Richtung wirkenden Linearmotors und ferromagnetische Führungsbahnen in Z- und Y-Richtung. Der Läufer trägt dann den Permanentmagnetkreis des Linearmotors und elektromagnetische Aktuatoren, bei denen die ferromagnetische Führungsbahn des Stators Teil des jeweiligen Magnetkreises ist, wodurch die notwendigen Lager- und Antriebskräfte zwischen den Führungsbahnen des Stators und dem Läufer berührungslos erzeugt werden.

Zur Regelung des Luftspaltes in Z-Richtung ist jeder Läufer mit vier solchen elektromagnetischen Aktuatoren ausgestattet, die sich paarweise am jeweiligen Stator gegenüberstehen, wobei die beiden Aktuatoren-Paare bei jeder Einheit einen in Richtung X gemessenen Abstand zueinander haben und so angesteuert werden, daß entweder ein Kräftegleichgewicht in einer gewünschten Position oder erforderliche Beschleunigungskräfte für Positionsänderungen erzeugt werden. Dadurch wird eine berührungsfreie magnetische Führung in Z-Richtung mit einstellbarem Luftspalt realisiert.

Zur Erzeugung der in Richtung Y wirkenden Lagerkraft und als Antrieb zur Parallelverschiebung der Geradführung in Richtung Y ist mindestens ein fünfter solcher elektromagnetischer Aktuator vorgesehen, wobei mit Ansteuerung dieses Aktuators eine Beeinflussung der in Richtung Y gemessenen Luftspalte erfolgt. Damit wird auch eine berührungsfreie magnetische Führung in Richtung Y realisiert.

Mit dieser Anordnung ist es vorteilhaft möglich, magnetische Führungen bzw. Antriebe für sechs Achsen synchron in Echtzeit anzusteuern bzw. zu regeln und zuverlässig zu beherrschen und dadurch Lageänderungen der Waferoberfläche in allen sechs Freiheitsgraden zu erzielen, nämlich durch Verschiebungen des Wafers in den Koordinatenrichtungen X, Y, Z sowie durch Drehungen um jede dieser Koordinatenrichtungen, und zwar jeweils unabhängig voneinander.

Die Führungsbahn der Geradführung und das Haltesystem sind vorzugsweise aus nichtmagnetischem Material ausgeführt. Es ist ein Schrittmotor vorhanden, dessen Drehbewegung über ein Seilzugsystem in die Linearbewegung des Haltesystems entlang der Geradführung gewandelt wird, und es sind Einrichtungen vorgesehen zur Klemmung des Haltesystems in einer vorgegebenen Verschiebeposition an der Geradführung, die beispielsweise in Form von Piezoaktuatoren ausgebildet sein können.

Vorteilhaft sollte das Haltesystem im wesentlichen aus einem aus Zerodur gefertigten Waferchuck zum Auflegen und elektrostatischen Halten der zu belichtenden bzw. zu messenden Substrate und aus einem aus Titan gefertigten Gestell zur Halterung des Waferchucks bestehen. Die Geradführung sollte vorteilhaft aus Keramik gefertigt sein, wobei das Gestell über ungeschmierte Keramikkugellager an die Geradführung gekoppelt ist.

Zur Messung der jeweils erreichten Verschiebepositionen des Haltesystems und/oder der Läufer in den Richtungen X und Y sind beispielsweise unabhängig voneinander arbeitende Interferometeranordnungen vorgesehen.

In diesem Fall sind an das Haltesystem, vorzugsweise an den Waferchuck, Spiegelflächen angearbeitet, die zur Messung der jeweils erreichten Verschiebepositionen mit den vorgesehenen Interferometeranordnungen dienen.

Zur Messung der Position des Substrates in Richtung Z können drei kapazitive Sensoren vorgesehen sein, die den Abstand der Substratoberfläche von einer festgelegten Bezugsebene messen.

Weiterhin sind in einer besonders bevorzugten Ausgestaltung der Erfindung Mittel zur magnetischen Abschirmung der Bereiche vorhanden, in denen die zur Belichtung und/oder Messung genutzte Strahlung verläuft. Diese Abschirmung schützt diese Strahlung gegen den Einfluß störender Magnetfelder, insbesondere gegen die Magnetfelder der Antriebe zur Neigungsänderung, Drehung und/oder Parallelverschiebung.

Die Abschirmung kann in Form von mehrlagigen Abschirmwandungen ausgebildet sein, wobei die Abschirmwandungen, die sich zwischen gegeneinander verschieblichen Baugruppen befinden, seitlich zueinander versetzt sind, so daß mäanderförmige magnetische Dichtungen entstehen.

Die gestellfesten Baugruppen der Linearmotoren, insbesondere Spulen, sollten gekühlt sein. Außerdem kann vorgesehen sein, die beweglichen Baugruppen der Linearmotoren, insbesondere die Läufer, mit einer wärmeabstrahlenden Oberflächenbeschichtung zu versehen.

Die Erfindung soll nachfolgend anhand eines Ausführungsbeispieles näher erläutert werden. In den zugehörigen Zeichnungen zeigen
- Fig.1: die erfindungsgemäße Anordnung in einer das Prinzip darstellenden Gesamtansicht von außen,
- Fig.2: die Gesamtansicht mit Darstellung der Geradführung, des Haltesys- tems und Anordnung der Antriebe,
- Fig.3: den prinzipiellen Aufbau einer der beiden Antriebseinheiten, mit denen sich wahlweise Parallelverschiebungen in Richtung der Koordinaten X und/oder Z bzw. Drehungen um die Richtungen X, Y und/oder Z reali- sieren lassen,
- Fig.4: ein Schema zur Erläuterung der Verstellbewegungen in den Freiheit- graden X, Y, Z, RX, RY, RZ.

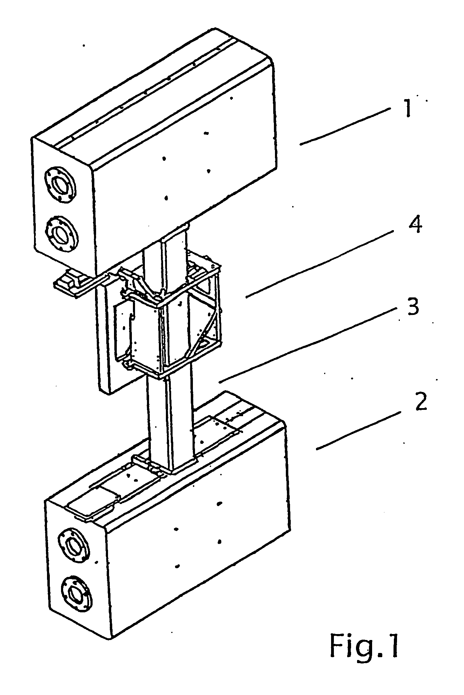

Aus Fig.1 ist ersichtlich, daß zwei Antriebseinheiten 1, 2 durch ein Keramikprofil, das Teil einer Geradführung 3 ist, verbunden sind. Das Keramikprofil der Geradführung 3 trägt ein nichtmagnetisches Haltesystem 4 für ein Substrat, hier beispielsweise für einen Wafer. Das Haltesystem 4 ist auf der Geradführung 3 verschieblich angeordnet.

Die Geradführung 3 ist einschließlich des Haltesystems 4 mittels der zwei Antriebseinheiten 1, 2 in einer Richtung parallel zur Substratoberfläche zu verschieben und mit geringer elastischer Nachgiebigkeit in alle Richtungen spielfrei geführt sowie angetrieben, wie weiter unten noch gezeigt wird.

Dabei wird erfindungsgemäß erreicht, daß das Haltesystem 4 durch die beiden Antriebseinheiten 1, 2, die mit der Länge der Geradführung 3 auseinanderstehen und auch getrennt voneinander magnetisch geschirmt sind, im Vakuumraum einer Einrichtung, die zum Belichten des Wafers und/oder zum Messen an dem Wafer mittels Strahlung dient, in allen sechs Raumfreiheitsgraden mit hoher Dynamik und Präzision positioniert werden kann.

Im Einbauzustand können die Antriebseinheiten 1, 2 selbstverständlich eine beliebige Lage im Raum einnehmen, bevorzugt ist aber eine horizontale Ausrichtung. In diesem Fall ist die Bewegungsrichtung des Haltesystems 4 entlang der Geradführung 3 vertikal, d. h. in Schwerkraftrichtung, ausgerichtet.

Das Keramikprofil der Geradführung 3 dient als Führungselement und kann gleichzeitig Antriebselemente aufnehmen, die zur Auslösung der Verschiebebewegung des Haltesystems 4 erforderlich sind (zeichnerisch nicht dargestellt).

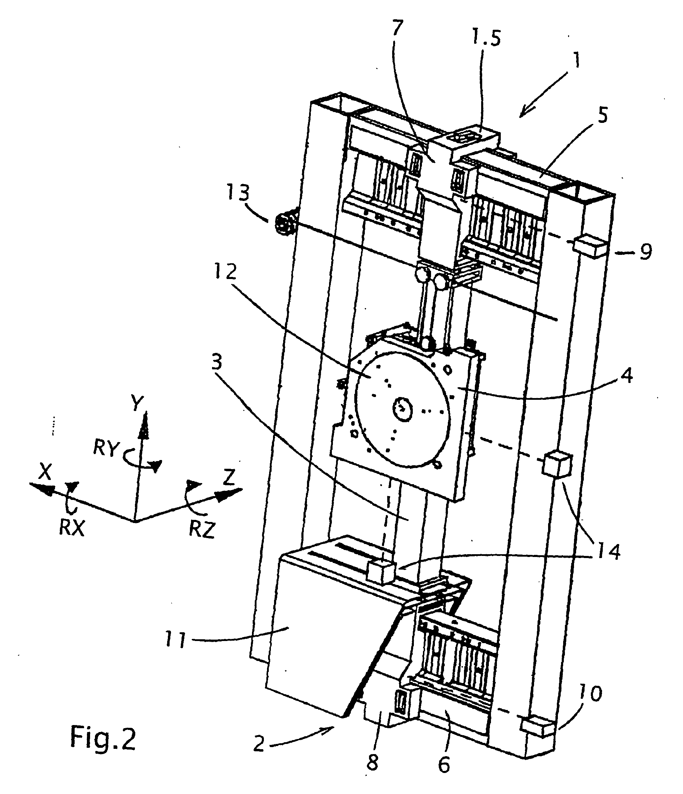

In Fig.2 ist angedeutet, daß die beiden Antriebseinheiten 1, 2 als Linearmotoren ausgebildet sind, wobei der Luftspalt zwischen Stator 5, 6 und Läufer 7, 8 jeweils veränderlich ist. An den Läufern 7, 8 befinden sich Magnetbrücken mit Permanentmagneten zur Kompensation des Gewichts der geführten Einheit. Sie sind derart ausgebildet, daß die in den Läufern 7, 8 integrierten Elektromagnete vergleichsweise geringe Kräfte für die Lagestabilisation erzeugen müssen und so die thermische Belastung reduziert wird.

Die beiden Antriebseinheiten 1, 2 sind in je vier Freiheitsgraden magnetisch geführt. In den restlichen beiden Freiheitsgraden erfolgt die Führung durch die Linearmotoren, bei denen keine mechanischen Berührungspunkte zwischen Stator 5, 6 und Läufer 7, 8 existieren. Die hochdynamische Feinstellbewegung wird durch die Regelung des Luftspaltes der Magnetführungen in den Freiheitsgraden Y, Z, RX, RY und die Positionierung der Linearmotoren in den Freiheitsgraden X, RZ innerhalb des Bewegungsbereiches realisiert.

Die Messung der Position der Läufer 7, 8 erfolgt mittels zweier unabhängig voneinander arbeitender Planspiegelinterferometer 9, 10. Zusätzlich sind kapazitive Sensoren (zeichnerisch nicht dargestellt) vorgesehen, die gemeinsam mit den Planspiegelinterferometern 9, 10 zur Messung der Position des Haltesystems 4 genutzt werden.

Weiterhin sind für jede Antriebseinheit magnetische Abschirmwandungen 11 zum Schutz des Teilchenstrahlbereiches vor störenden Magnetfeldern vorgesehen, die jeweils mehrlagig ausgeführt ist, wobei die für die Bewegungsübertragung nötigen Schlitze in den einzelnen Lagen zueinander seitlich versetzt liegen und somit eine mäanderförmige magnetische Dichtung entsteht, welche eine steife Verbindung der Läufer 7, 8 mit dem magnetfeldfreien Haltesystem 4 ermöglicht. In Fig.2 ist die magnetische Abschirmwandungen 11 der Übersichtlichkeit wegen nur bei der Antriebseinheit 2 angedeutet.

Um störende thermische Ausdehnung der Baugruppen der Antriebseinheiten 1, 2 und insbesondere auch der Baugruppen des Haltesystems 4 zu vermeiden, sind die gestellfesten Spulen der Linearmotoren mit ihrer Halterung wassergekühlt. Diese Halterung wie auch die Oberflächen der Läufer 7, 8 sind darüber hinaus mit einer geeigneten Oberflächenbeschichtung versehen, so daß eine effektive Strahlungskühlung zur Abführung der Wärme der Magnetlager realisiert wird (zeichnerisch nicht dargestellt).

Linearmotoren und Magnetlager sind vorteilhafterweise außerhalb des Teilchenstrahlbereiches, d. h. außerhalb des Bereiches, in denen die zur Belichtung und/oder Messung genutzte Strahlung verläuft, angeordnet und nicht direkt am Haltesystem 4 für das Substrat montiert. Sie sind um diesen Teilchenstrahlbereich herum angeordnet, wobei eine symmetrische Anordnung bevorzugt ist.

In Fig.2 ist weiterhin erkennbar, daß das Haltesystem 4 mit einem Waferchuck 12 zur Aufnahme des Wafers bei vertikal ausgerichteter Waferoberfläche ausgestattet ist. Ein Schrittmotorantrieb 13 ermöglicht dabei eine (grobe) Positionierung über einen Zustellbereich von etwa 320 mm hinweg in der senkrechten Y-Achse.

Der Waferchuck 12, auf dem der Wafer elektrostatisch gehalten wird, ist hochpräzise aus temperaturstabilem Zerodur gefertigt. An den Waferchuck 12 sind seitlich Spiegelflächen angearbeitet, die zur Ermittlung und Kontrolle der Chuckposition mit einer 6-Strahl-Laserinterferometeranordnung 14 (Auflösung 0.6 nm) in allen Raumfreiheitsgraden außer der Koordinate Z dienen. Die Lage des Wafers zur Koordinate Z wird direkt auf der Waferoberfläche mit Hilfe von drei hochgenauen kapazitiven Sensoren (nicht dargestellt) ermittelt. Die damit gewonnenen Meßsignale werden im folgenden auch als "globale" Signale bezeichnet, da sie die unmittelbare Position des zu belichtenden Wafers repräsentieren.

Der Waferchuck 12 ist spannungsfrei an ein Gestell aus Titanprofilen gekoppelt, welches senkrecht und mit Hilfe von ungeschmierten Keramikkugellagern an dem Keramikprofil der Geradführung 3 entlang geführt wird. Die Einkopplung der senkrechten Bewegung für das Haltesystem 4 mit dem Waferchuck 12 erfolgt, wie bereits erläutert, über von einem schnellen Schrittmotor 13 angetriebenen Seilzug.

Mit Hilfe von Piezoaktuatoren (nicht dargestellt) kann das Gestell in jeder beliebigen senkrechten Y-Koordinate im Bereich von ±160 mm mit einer Genauigkeit von ca. ±10 µm geklemmt werden. Dabei ergeben sich Wiederholgenauigkeiten im Bereich von wenigen µm / µrad in allen anderen Koordinaten. Nach dem Erreichen der angestrebten senkrechten Position des Wafers wird das Seil des Seilzugs entspannt, um dessen Einfluß auf die Antriebseinheiten 1, 2 zu minimieren.

Die in den Antriebseinheiten 1, 2 vorgesehenen elektrodynamischen Direktantriebe bzw. Linearmotoren sind magnetisch geführt und dreifach abgeschirmt (Abschirmwandungen 11). Sie ermöglichen eine hochgenaue horizontale X-Bewegung von ±160 mm, welche mit Hilfe der zwei Planspiegelinterferometer 9, 10 mit einer Auflösung von 5 nm am oberen und unteren Linearmotor gemessen wird. Ein gesteuertes asynchrones Verfahren der beiden Linearmotoren führt zur Drehung RZ.

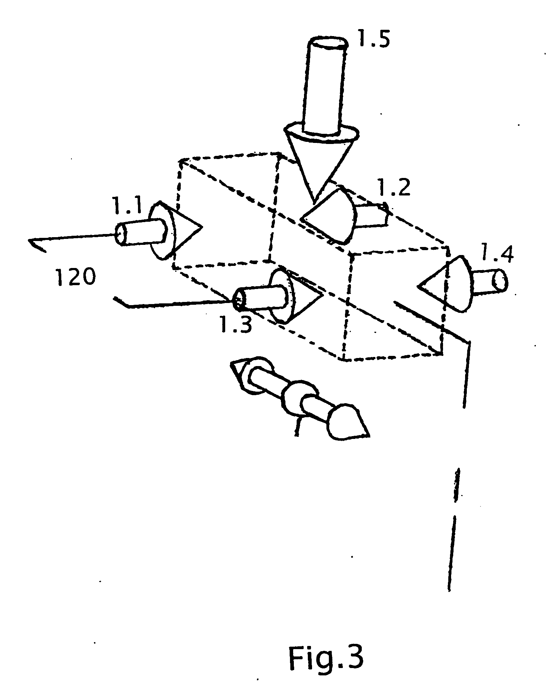

Jede Antriebseinheit 1, 2 ist mit insgesamt fünf elektromagnetischen Aktuatoren 1.1, 1.2, 1.3, 1.4, 1.5 bzw. 2.1, 2.2, 2.3, 2.4, 2.5 ausgestattet, wovon jeweils vier zur Realisierung von Verstellbewegungen in Z-Richtung (die Aktuatoren 1.1, 1.2, 1.3, 1.4 bzw. 2.1, 2.2, 2.3, 2.4) und jeweils einer (die Aktuatoren 1.5 bzw. 2.5) zur Realisierung von Verstellbewegungen in Y-Richtung dienen. In Fig.3 ist die Anordnung der Aktuatoren 1.1, 1.2, 1.3, 1.4 und 1.5 in der Antriebseinheit 1 dargestellt.

Jeder dieser Aktuatoren 1.1, 1.2, 1.3, 1.4, 1.5 bzw. 2.1, 2.2, 2.3, 2.4, 2.5 besitzt sein eigenes, "lokales" kapazitives Meßsystem zur hochgenauen Messung des Luftspaltes zwischen Stator und Läufer bzw. zwischen der Wirkfläche des Aktuators und der Führungsfläche am Stator im Bereich von ±0.5 mm bei einer Auflösung von 20 nm. Durch die gezielte Beeinflussung der Breite des Luftspalts wird eine Bewegung in den Koordinaten Y, Z, RY und RX ermöglicht.

Die Aktuatoren 1.5 und 2.5 sind in diesem Falle hybrid ausgelegt, d. h. sie besitzen eingebaute Permanentmagnete, die verlustleistungsfrei den überwiegenden Teil der Gewichtskraft zu bewegenden Masse von ca. 50 kg kompensieren. Sofern in anderen Ausführungen der Erfindung nicht die Y-Koordinate, sondern, die Z-Koordinate in Richtung der Schwerkraft weisen sollte, sind die Aktuatoren 1.1, 1.2, 1.3, 1.4 bzw. 2.1, 2.2, 2.3, 2.4 in diesem Sinne ausgelegt.

Unter Berücksichtigung der geometrischen Daten der Anordnung, die in Fig.3 angedeutet sind, und der Auflösung der Meßsysteme der einzelnen "lokalen" Aktuatoren 1.1, 1.2, 1.3, 1.4, 1.5 bzw. 2.1, 2.2, 2.3, 2.4, 2.5 ergeben sich die folgenden (theoretischen) Verfahrbereiche und Positionsauflösungen in den einzelnen Koordinaten: X ±160mm (5nm); Y ±160mm als Gesamtverfahrbereich bzw. ±0.5mm als Parallelverschiebung (20nm); Z ±0.5mm (5nm); RX ±0.4mrad (16nrad); RY ±4mrad (160nrad); RZ ±5mrad (6nrad).

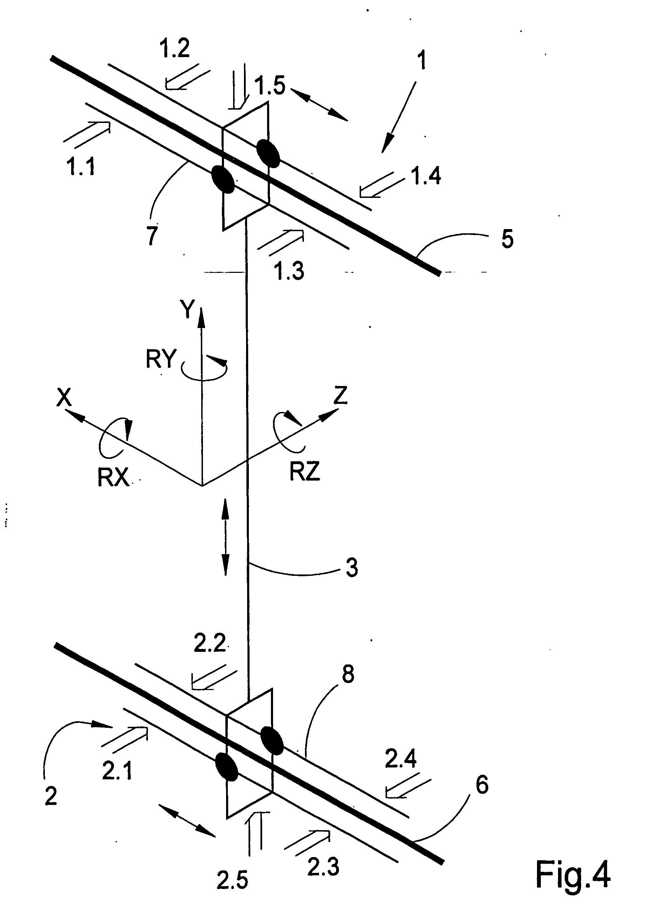

Anhand Fig.4 sei nochmals die Realisierung der Verstellbewegungen in den Freiheitsgraden X, Y, Z, RX, RY, RZ erläutert. Zu erkennen sind die symbolisch dargestellte Geradführung 3, die Antriebseinheit 1 mit dem Stator 5, dem Läufer 7 und den Aktuatoren 1.1, 1.2, 1.3, 1.4, 1.5 sowie die Antriebseinheit 2 mit dem Stator 6, dem Läufer 8 und den Aktuatoren 2.1, 2.2, 2.3, 2.4, 2.5. Die Aktuatoren 1.1, 1.2, 1.3, 1.4 sind zur Veränderung der in Richtung Z gemessenen Breite des Luftspaltes zwischen dem Stator 5 und dem Läufer 7 an der Antriebseinheit 1 vorgesehen, die Aktuatoren 2.1, 2.2, 2.3, 2.4 zur Veränderung der in Richtung Z gemessenen Breite des Luftspaltes zwischen dem Stator 6 und dem Läufer 8 an der Antriebseinheit 2. Der Aktuator 1.5 an der Antriebseinheit 1 und der Aktuator 2.5 an der Antriebseinheit 2 dienen zur Veränderung der in Richtung Y gemessenen Breite der Luftspalte.

Die Verstellbewegungen werden wie folgt realisiert:
Parallelverschiebung in der Koordinate X nach der einen oder anderen Richtung durch Synchronansteuerung der Linearmotoren (Läufer 7 in der Antriebseinheit 1 und Läufer 8 in der Antriebseinheit 2);
Parallelverschiebung in der Koordinate Y nach der einen oder anderen Richtung durch Synchronansteuerung der Aktuatoren 1.5 und 2.5;
Parallelverschiebung in der Koordinate Z nach der einen oder anderen Richtung durch Synchronansteuerung der Aktuatoren-Paare 1.1/1.2 und 1.3/1.4 und der Aktuatoren-Paare 2.1/2.2 und 2.3/2.4;
Drehung RX um die Koordinate X durch Ansteuerung der Aktuatoren-Paare 1.1/1.2 und 1.3/1.4 asynchron zur Ansteuerung der Aktuatoren-Paare 2.1/2.2 und 2.3/2.4 (und damit gegenläufige Veränderung der Luftspalte bei den Linearmotoren);
Drehung RY um die Koordinate Y durch Ansteuerung der Aktuatoren-Paare 1.1/1.2 und 2.1/2.2 asynchron zur Ansteuerung der Aktuatoren-Paare 1.3/1.4 und 2.3/2.4 (und damit gegenläufige Veränderung der Luftspalte innerhalb beider Linearmotoren;
Drehung RZ um die Koordinate Z durch Ansteuerung des Linearmotors in der Antriebseinheiten 1 asynchron zur Ansteuerung des Linearmotors in der Antriebseinheiten 2.

Die gewählte Anordnung hat folgende Vorteile: Eine in sich geschlossene Einheit kann hochpräzise in allen sechs Raumfreiheitsgraden bewegt werden. Sie ist magnetisch geführt und "schwebt" nahezu berührungsfrei (abgesehen von elektrischen Zuführungen und dem Einfluß des Seilzugs) im Raum, ist also weitgehend frei von Reibung und Verschleiß. Die Antriebe als potentielle Störfeldquellen sind mit mehr als einem halben Meter verhältnismäßig weit entfernt vom Ort der Belichtung. Das von den Antrieben ausgehende Feld kann durch eine geeignete, im vorliegenden Fall dreifache Abschirmung weiter drastisch reduziert werden.

Ein weiter Bereich um den belichtenden lonenstrahl herum ist eisenfrei, die Verzerrung der Belichtung wird dadurch minimiert. Durch die permanentmagnetbasierte Gewichtskompensation in der magnetischen Führung können die elektromagnetischen Aktuatoren der Führung mit nahezu Null statischem Strom betrieben werden, was zu einem geringen Leistungsumsatz und damit zu einer geringen Erwärmung der Antriebe im Vakuum führt. Die Spulen in den Direktantrieben für die schnelle und genaue horizontale Positionierung sind statisch montiert und daher leicht zu kühlen.

Um einen ausreichenden Verfahrbereich in den Rotationsachsen, insbesondere RX, zu gewährleisten, sind große Arbeitsluftspalte in der magnetischen Führung erforderlich. Das hat bei den Rotationsachsen mit geringerem Basisabstand, hier RY, eine geringere Auflösung zur Folge.

Vorteilhaft befinden sich die Antriebseinheiten 1, 2 jeweils in einem Gehäuse aus Stahl. Dieses Stahlgehäuse ist zugleich die erste Schicht der magnetischen Schirmung; zwei weitere Schichten aus MuMetal werden angebracht, nachdem die Antriebseinheiten 1, 2 vollständig eingebaut und ausgerichtet sind. Jede Abschirmung ist mit einer Labyrinthdichtung für das von den Antriebseinheiten 1, 2 ausgehende magnetische Störfeld versehen, durch das die Bewegung nach außen geführt wird. Versuche in einer Abschirmkammer haben gezeigt, daß durch die dreischichtige Abschirmung das aus einem Antrieb austretende magnetische Feld auf 10 nT (statisch) und 5 pT (dynamisch) am Belichtungsort reduziert werden kann.

Auch wurde die Problematik des Ausgasens und der Erwärmung der Antriebselemente untersucht. Als Spulenmaterial kommt Aluminiumfolie zum Einsatz, die allseitig mit einer Oxidschicht versehen ist. Die ebenfalls mit einer Oxidschicht versehenen Spulenkörper verhindern weitgehend die Bildung von Wirbelströmen und führen so zu einer geringeren Erwärmung und zu einer kleinen Zeitkonstante der Spulen. Die in den Spulen der elektrodynamischen Direktantriebe entstehende Wärme wird an den Enden der Spulenkörper durch Kupferblöcke mit Kanälen für eine Kühlflüssigkeit abgeführt. Diese geben dem Stator des Direktantriebs zusätzlich eine stabile Doppel-T-Form.

Für die in den Aktuatoren der Direktantriebe befindlichen Elektromagnete bzw. deren Spulen wurde ein anderer Weg beschritten. Um die Zahl der Zuführungen zum bewegten Teil so gering wie möglich zu halten, wurde hier auf Kühlleitungen verzichtet. Die Elektromagnete wurden dafür auf ein kleines Strom-Kraft- und ein großes Kraft-Masse-Verhältnis hin optimiert. Im Ergebnis dessen erreichen die Elektromagnete der Z-Führung bei einer Kraft von 100 N und einem Luftspalt von 1 mm eine Verlustleistung von nur 3 W bei einem Gewicht von je 0.6 kg, während es für die aufgrund der nicht ganz vollständigen Gewichtskompensation stärker belasteten Y-Elektromagneten 1.4 kg und 1.3 W bei 100 N und 1 mm Luftspalt sind. Die genannten Kräfte werden allerdings nur bei starken Beschleunigungen und üblicherweise bei kleineren Luftspalten (um etwa 0.5 mm) benötigt. Da die Elektromagnete mit nahezu Null statischem Strom betrieben werden (abgesehen von kleinen, ständig aufzubringenden Kräften für Moment- und Restgewicht-Kompensationen) ist die durchschnittliche Leistungsaufnahme wesentlich geringer. Sie liegt bei insgesamt ungefähr 0.5 W in der gesamten magnetischen Führung eines Direktantriebes. Die daraus abgeschätzte Übertemperatur in unmittelbarer Umgebung der Spulen der Elektromagnete beträgt 3K, was sich über den gesamten Antrieb auf <1 K reduziert. Da sowohl Aktuator als auch Stator im Direktantrieb mit einer schwarzen Aluminiumoxidschicht versehen sind, erfolgt zumindest teilweise eine Abgabe der in den Führungen verbrauchten Leistung über Strahlungswärme an den gekühlten Stator.

Insgesamt zeigt dieses Beispiel für ein Positioniersystem einen magnetisch geführten, elektrodynamisch angetriebenen hochpräzisen senkrechten Wafertisch, der sehr geringe magnetische Störfelder emittiert und für den Einsatz im Hochvakuum geeignet ist. Mit diesem Tisch werden trotz erschwerter Systemumgebung Positionsruhen und -genauigkeiten im Sub-µm- bzw. µrad-Bereich und zudem ein besonders hoher Gleichlauf des Wafertischs erreicht.

### Bezugszeichenliste

- 1: Antriebseinheit
- 1.1, 1.2, 1.3, 1.4, 1.5: Aktuatoren
- 2: Antriebseinheit
- 2.1, 2.2, 2.3, 2.4, 2.5: Aktuatoren
- 3: Geradführung
- 4: Haltesystem
- 5, 6: Stator
- 7, 8: Läufer
- 9, 10: Planspiegelinterferometer
- 11: Abschirmwandungen
- 12: Waferchuck
- 13: Schrittmotorantrieb

- X, Y, Z: Koordinaten
- RX, RY, RZ: Rotationsachse

## Patentansprüche

1. Anordnung zum Positionieren von Substraten, insbesondere zum Positionieren von Wafern innerhalb einer Einrichtung zum Belichten und/oder Messen mittels Strahlung unter Hochvakuumbedingungen, umfassend
- ein auf einer Geradführung (3) verschiebliches Haltesystem (4) zur Aufnahme des Substrates, wobei die Führungsrichtung der Geradführung (3) parallel oder im wesentlichen parallel zur Koordinate Y eines Raumkoordinatensystems X, Y, Z ausgerichtet ist,
- Antriebe zur begrenzten Neigungsänderung der Führungsrichtung relativ zur Koordinate Y,
- Antriebe zur begrenzten Drehung der Geradführung (3) einschließlich des Haltesystems (4) um die Führungsrichtung sowie
- Antriebe zur Parallelverschiebung der Geradführung (3) einschließlich des Haltesystems (4) in Richtung der Koordinate X, in Richtung der Koordinate Y und/oder in Richtung der Koordinate Z.

2. Anordnung nach Anspruch 1, **dadurch gekennzeichnet, daß** zur Erzeugung der Neigungsänderung, Drehung und/oder Parallelverschiebung in Richtung der Koordinaten X und Z zwei Antriebseinheiten (1, 2) vorgesehen sind, von denen jede einen Linearmotor mit veränderlichem Luftspalt zwischen Stator (5, 6) und Läufer (7, 8) aufweist, wobei die Läufer (7, 8) in Richtung X verschieblich und jeder Läufer (7, 8) mit einem entgegengesetzten Ende der Geradführung (3) verbunden ist, so daß
- bei synchroner Verschiebung beider Läufer (7, 8) die Parallelverschiebung in Richtung X, dagegen bei asynchroner Verschiebung beider Läufer (7, 8) die Neigungsänderung in Richtung X erfolgt,
- bei synchroner Veränderung der Luftspalte in beiden Linearmotoren die Parallelverschiebung in Richtung Z oder die Drehung RY, dagegen bei asynchroner Veränderung der Luftspalte in beiden Linearmotoren die Neigungsänderung in Richtung Z erfolgt.

3. Anordnung nach Anspruch 2, **dadurch gekennzeichnet, daß** zur Variation des Luftspaltes jeder Linearmotor mit vier elektromagnetischen Aktuatoren (1.1, 1.2, 1.3, 1.4; 2.1, 2.2, 2.3, 2.4) ausgestattet ist, die sich paarweise am jeweiligen Stator (5, 6) gegenüberstehen, wobei die beiden Aktuatoren-Paare (1.1/1.2 und 1.3/1.4 bzw. 2.1/2.2 und 2.3/2.4) bei jedem Linearmotor einen in Richtung X gemessenen Abstand zueinander haben und wobei die Parallelverschiebung in Richtung Z durch eine synchrone Betätigung beider Aktuatoren-Paare (1.1/1.2 und 1.3/1.4 bzw. 2.1/2.2 und 2.3/2.4) an beiden Linearmotoren und die Drehung RX durch synchrone Betätigung jeweils eines Aktuatoren-Paares (1.1/1.2 oder 1.3/1.4 bzw. 2.1/2.2 oder 2.3/2.4) an beiden Linearmotoren erzielt wird.

4. Anordnung nach einem der vorgenannten Ansprüche, **dadurch gekennzeichnet, daß** als Antrieb zur Parallelverschiebung der Geradführung (3) in Richtung Y mindestens ein elektromagnetischer Aktuator (1.5) vorgesehen ist, wobei mit Ansteuerung dieses Aktuators (1.5) eine Änderung der in Richtung Y gemessenen Luftspalte bei den Linearmotoren erfolgt.

5. Anordnung nach einem der vorgenannten Ansprüche, **dadurch gekennzeichnet, daß** die Führungsbahn der Geradführung (3) und das Haltesystem (4) aus nichtmagnetischem Material ausgeführt sind, ein Schrittmotor (13) vorhanden ist, dessen Drehbewegung über ein Seilzugsystem in die Linearbewegung des Haltesystems (4) entlang der Geradführung (3) gewandelt wird und Einrichtungen, insbesondere Piezoaktuatoren, zur Klemmung des Haltesystems (4) in einer vorgegebenen Verschiebeposition an der Geradführung (3) vorgesehen sind.

6. Anordnung nach einem der vorgenannten Ansprüche, **dadurch gekennzeichnet, daß** das Haltesystem (4) im wesentlichen aus einem aus Zerodur gefertigten Waferchuck (12) zum Auflegen und elektrostatischen Halten der zu belichtenden bzw. zu messenden Substrate und aus einem aus Titan gefertigten Gestell zur Halterung des Waferchucks (12) besteht und die Geradführung (3) aus Keramik gefertigt ist, wobei das Gestell über ungeschmierte Keramikkugellager an die Geradführung (3) gekoppelt ist.

7. Anordnung nach einem der vorgenannten Ansprüche, **dadurch gekennzeichnet, daß** zur Messung der jeweils erreichten Verschiebepositionen des Haltesystems (4) und/oder der Läufer (7, 8) in den Richtungen X und Y unabhängig voneinander arbeitende Interferometeranordnungen (9, 10, 14) vorgesehen sind.

8. Anordnung nach Anspruch 7, **dadurch gekennzeichnet, daß** an das Haltesystem (4), vorzugsweise an den Waferchuck (12), Spiegelflächen angearbeitet sind, die zur Messung der jeweils erreichten Verschiebepositionen mit den vorgesehenen Interferometeranordnungen (14) dienen.

9. Anordnung nach einem der vorgenannten Ansprüche, **dadurch gekennzeichnet, daß** zur Messung der Position des Substrates in Richtung Z drei kapazitive Sensoren vorgesehen sind, die den Abstand der Substratoberfläche von einer festgelegten Bezugsebene messen.

10. Anordnung nach einem der vorgenannten Ansprüche, **dadurch gekennzeichnet, daß** Mittel zur magnetischen Abschirmung der Bereiche, in denen die zur Belichtung und/oder Messung genutzte Strahlung verläuft, gegen störende Magnetfelder, insbesondere gegen Magnetfelder der Antriebe zur Neigungsänderung, Drehung und/oder Parallelverschiebung vorgesehen sind.

11. Anordnung nach Anspruch 10, **dadurch gekennzeichnet, daß** mehrlagige Abschirmwandungen (11) vorhanden sind, wobei die Abschirmwandungen (11) zwischen gegeneinander verschieblichen Baugruppen seitlich zueinander versetzt sind, so daß mäanderförmige magnetische Dichtungen ausgebildet sind.

12. Anordnung nach einem der vorgenannten Ansprüche, **dadurch gekennzeichnet, daß** die gestellfesten Baugruppen der Linearmotoren, insbesondere Spulen, gekühlt sind und/oder die beweglichen Baugruppen der Linearmotoren, insbesondere die Läufer, mit einer wärmeabstrahlenden Oberflächenbeschichtung versehen sind.

## Claims

1. Assembly for positioning substrates, in particular for positioning wafers within a device for exposure and/or measurement by means of radiation under high-vacuum conditions, said assembly comprising
- a holding system (4) for receiving the substrate, said holding system (4) being displaceable on a straight guide (3), the guiding direction of the straight guide (3) being parallel or substantially parallel to the coordinate Y of a space coordinate system X, Y, Z,
- drives for the limited modification of inclination of the guiding direction relative to the coordinate Y,
- drives for the limited rotation of the straight guide (3), including the holding system (4), about the guiding direction, as well as
- drives for parallel displacement of the straight guide (3), including the holding system (4), in the direction of the coordinate X, in the direction of the coordinate Y, and/or in the direction of the coordinate Z.

2. Assembly according to claim 1, **characterized in that** in order to produce the modification of inclination, the rotation and/or the parallel displacement in the direction of the coordinates X and Z, two drive units (1, 2) are provided, each comprising a linear motor with a variable air gap between stator (5, 6) and rotor (7, 8), the rotors (7, 8) being displaceable in the direction X and each rotor (7, 8) being connected to an opposite end of the straight guide (3), so that,
in the case of a synchronous displacement of both rotors (7, 8), the parallel displacement in the direction X takes place, whereas in the case of an asynchronous displacement of both rotors (7, 8), the modification of inclination in the direction X takes place,
- in the case of a synchronous modification of the air gaps in both linear motors, the parallel displacement in the direction Z or the rotation RY takes place, whereas in the case of an asynchronous modification of the air gaps in both linear motors, the modification of inclination in the direction Z takes place.

3. Assembly according to claim 2, **characterized in that**, in order to vary the air gap, each linear motor is equipped with four electromagnetic actuators (1.1, 1.2, 1.3, 1.4; 2.1, 2.2, 2.3, 2.4), which are arranged in opposite pairs at the respective stator (5, 6), both actuator pairs (1.1/1.2 and 1.3/1.4, or 2.1/2.2 and 2.3/2.4, respectively) of each linear motor having a mutual spacing, measured in the direction X, and the parallel displacement in the direction Z being achieved by synchronous actuation of both actuator pairs (1.1/1.2 and 1.3/1.4, or 2.1/2.2 and 2.3/2.4, respectively) at both linear motors and the rotation RX being achieved by synchronous actuation of one actuator pair (1.1/1.2 or 1.3/1.4 and 2.1/2.2 or 2.3/2.4, respectively) each at both linear motors.

4. Assembly according to any one of the preceding claims, **characterized in that** at least one electromagnetic actuator (1.5) is provided as a drive for the parallel displacement of the straight guide (3) in the direction Y, the control of this actuator (1.5) causing a modification of the air gaps of the linear motors, said air gaps being measured in the direction Y.

5. Assembly according to any one of the preceding claims, **characterized in that** the guideway of the straight guide (3) and the holding system (4) are made of non-magnetic material, a stepping motor (13) is present, whose rotary movement is transformed into the linear movement of the holding system (4) along the straight guide (3) via a traction cable system, and devices, in particular piezo actuators, are provided for clamping the holding system (4) in a predefined position of displacement on the straight guide (3).

6. Assembly according to any one of the preceding claims, **characterized in that** the holding system (4) consists substantially of a wafer chuck (12) made of zerodur for application and electrostatic holding of the substrates to be exposed and/or measured, and of a rack made of titanium for holding the wafer chuck (12), and the straight guide (3) is made of ceramics, the rack being coupled to the straight guide (3) via unlubricated ceramic ball bearings.

7. Assembly according to any one of the preceding claims, **characterized in that** interferometer assemblies (9, 10, 14), working independently of each other, are provided to measure the respectively reached positions of displacement of the holding system (4) and/or of the rotors (7, 8) in the directions X and Y.

8. Assembly according to claim 7, **characterized in that** reflecting surfaces are formed on the holding system (4), preferably on the wafer chuck (12), which surfaces serve to measure the respectively reached positions of displacement using the provided interferometer assemblies (14).

9. Assembly according to any one of the preceding claims, **characterized in that** three capacitive sensors measuring the distance of the substrate surface from a defined reference plane are provided to measure the position of the substrate in the direction Z.

10. Assembly according to any one of the preceding claims, **characterized in that** means for magnetic shielding of the areas in which the radiation used for exposure and/or measurement extends are provided against parasitic magnetic fields, in particular against magnetic fields of the drives for modification of the inclination, for rotation and/or for parallel displacement.

11. Assembly according to claim 10, **characterized in that** multilayer shielding walls (11) are present, said shielding walls (11) being laterally offset with respect to each other between mutually displaceable components so that meander-shaped magnetic seals are formed.

12. Assembly according to any one of the preceding claims, **characterized in that** those components of the linear motors which are fixed with respect to the rack, in particular the coils, are cooled and/or the movable components of the linear motors, in particular the rotors, are provided with a heat-dissipating surface coating.

## Revendications

1. Ensemble pour le positionnement de substrats, notamment pour le positionnement de wafers dans un dispositif d'exposition et/ou de mesure par rayonnement dans des conditions de vide élevé, ledit ensemble comprenant
- un système de maintien (4) recevant le substrat, ledit système de maintien (4) étant déplaçable sur un guide rectiligne (3), la direction de guidage du guide rectiligne (3) étant parallèle ou sensiblement parallèle à la coordonnée Y d'un système de coordonnées spatiales X, Y, Z,
- des entraînements pour la modification limitée de l'inclinaison de la direction de guidage par rapport à la coordonnée Y,
- des entraînements pour la rotation limitée du guide rectiligne (3), y compris le système de maintien (4), autour de la direction de guidage, ainsi que
- des entraînements pour le déplacement parallèle du guide rectiligne (3), y compris le système de maintien (4), en direction de la coordonnée X, en direction de la coordonnée Y, et/ou en direction de la coordonnée Z.

2. Ensemble selon la revendication 1, **caractérisé en ce que** l'on prévoit deux unités d'entraînement (1, 2) produisant la modification d'inclinaison, la rotation et/ou le déplacement parallèle en direction des coordonnées X et Z, chaque unité d'entraînement (1, 2) comprenant un moteur linéaire présentant un entrefer variable entre stator (5, 6) et rotor (7, 8), les rotors (7, 8) étant déplaçables dans la direction X et chaque rotor (7, 8) étant raccordé à une extrémité opposée du guide rectiligne (3), de sorte que,
lors d'un déplacement synchrone des deux rotors (7, 8), le déplacement parallèle dans la direction X a lieu, tandis que lors d'un déplacement asynchrone des deux rotors (7, 8), la modification d'inclinaison dans la direction X a lieu,
- lors d'une modification synchrone des entrefers dans les deux moteurs linéaires, le déplacement parallèle dans la direction Z ou la rotation RY a lieu, tandis que, lors d'une modification asynchrone des entrefers dans les deux moteurs linéaires, la modification d'inclinaison dans la direction Z a lieu.

3. Ensemble selon la revendication 2, **caractérisé en ce que**, pour varier l'entrefer, chaque moteur linéaire est équipé de quatre actionneurs électromagnétiques (1.1, 1.2, 1.3, 1.4; 2.1, 2.2, 2.3, 2.4), qui sont disposés sur le stator (5, 6) respectif par paires opposées, les deux paires d'actionneurs (1.1/1.2 et 1.3/1.4, ou 2.1/2.2 et 2.3/2.4, respectivement) de chaque moteur linéaire présentant un écartement mutuel mesuré dans la direction X, et le déplacement parallèle dans la direction Z étant obtenu par actionnement synchrone des deux paires d'actionneurs (1.1/1.2 et 1.3/1.4, ou 2.1/2.2 et 2.3/2.4, respectivement) sur les deux moteurs linéaires, et la rotation RX étant obtenue par actionnement synchrone d'une paire respective d'actionneurs (1.1/1.2 ou 1.3/1.4 et 2.1/2.2 ou 2.3/2.4, respectivement) sur les deux moteurs linéaires.

4. Ensemble selon l'une quelconque des revendications précédentes, **caractérisé en ce que** l'on prévoit au moins un actionneur électromagnétique (1.5) comme entraînement pour le déplacement parallèle du guide rectiligne (3) dans la direction Y, la commande de cet actionneur (1.5) produisant une modification des entrefers des deux moteurs linéaires, ces entrefers étant mesurés dans la direction Y.

5. Ensemble selon l'une quelconque des revendications précédentes, **caractérisé en ce que** la voie de guidage du guide rectiligne (3) et le système de maintien (4) sont constitués d'un matériau antimagnétique, qu'un moteur pas à pas (13) est présent, dont le mouvement de rotation est transformé en le mouvement linéaire du système de maintien (4) selon le guide rectiligne (3) par un système à câble de traction, et **en ce que** l'on prévoit des dispositifs, notamment des actionneurs piézo-électriques, pour enserrer le système de maintien (4) dans une position prédéfinie du déplacement sur le guide rectiligne (3).

6. Ensemble selon l'une quelconque des revendications précédentes, **caractérisé en ce que** le système de maintien (4) est constitué sensiblement d'un chuck pour wafer (12) fabriqué en zérodur pour l'application et le maintien électrostatique des substrats à exposer et/ou à mesurer, et d'un bâti fabriqué en titane pour le maintien du chuck pour wafer (12), et **en ce que** le guide rectiligne (3) est fabriqué en céramique, le bâti étant couplé au guide rectiligne (3) au moyen de roulements non graissés à billes céramiques.

7. Ensemble selon l'une quelconque des revendications précédentes, **caractérisé en ce que** l'on prévoit des ensembles interférométriques (9, 10, 14), travaillant de manière indépendante les uns des autres, pour mesurer les positions de déplacement respectivement atteintes du système de maintien (4) et/ou des rotors (7, 8) dans les directions X et Y.

8. Ensemble selon la revendication 7, **caractérisé en ce que** des surfaces réfléchissantes sont formées sur le système de maintien (4), de préférence sur le chuck pour wafer (12), lesdites surfaces servant à mesurer, à l'aide des ensembles interférométriques (14) prévus, les positions de déplacement respectivement atteintes.

9. Ensemble selon l'une quelconque des revendications précédentes, **caractérisé en ce que** l'on prévoit, pour mesurer la position du substrat dans la direction Z, trois capteurs capacitifs mesurant la distance entre la surface de substrat et un plan de référence défini.

10. Ensemble selon l'une quelconque des revendications précédentes, **caractérisé en ce que** l'on prévoit des moyens pour la protection magnétique des régions, dans lesquelles s'étend le rayonnement utilisé pour l'exposition et/ou la mesure, contre des champs magnétiques parasites, notamment contre des champs magnétiques des entraînements pour la modification d'inclinaison, pour la rotation et/ou pour le déplacement parallèle.

11. Ensemble selon la revendication 10, **caractérisé en ce que** des parois multicouches (11) de protection sont présentes, lesdites parois (11) de protection étant latéralement décalées les unes par rapport aux autres entre des composants mutuellement déplaçables, de manière à réaliser des joints magnétiques se présentant sous la forme d'un méandre.

12. Ensemble selon l'une quelconque des revendications précédentes, **caractérisé en ce que** les composants des moteurs linéaires qui sont fixés par rapport au bâti, notamment les bobines, sont refroidis et/ou les composants amovibles des moteurs linéaires, notamment les rotors, présentent un revêtement de surface dissipant la chaleur.
